# EUROPEAN PATENT SPECIFICATION

(11) **EP 4 269 509 B1**
(45) Date of publication and mention of the grant of the patent: **03.09.2025**
(21) Application number: 21914939.0
(22) Date of filing: 29.06.2021
(51) Int. Cl.: C09D 11/52, C09D 11/322, C09D 11/107, C09D 11/38, C09D 11/326, H01B 1/22, B41M 5/00, H01B 13/00

(54) **METALLIC FINE PARTICLE-CONTAINING INK**
FEINE METALLTEILCHEN ENTHALTENDE TINTE
ENCRE À TENEUR EN MICROPARTICULES DE MÉTAL

(30) Priority: 28.12.2020 JP 2020219523
(43) Date of publication of application: 01.11.2023
(73) Proprietor: Kao Corporation, Chuo-ku Tokyo 103-8210 (JP)
(72) Inventor: YOSHIDA, Tomohide, Wakayama-shi, Wakayama 640-8580 (JP); MUTO, Kosuke, Wakayama-shi, Wakayama 640-8580 (JP)
(74) Representative: Hoffmann Eitle
(86) International application number: PCT/JP2021/024501
(87) International publication number: WO 2022/145077

(56) References cited:
- WO-A1-2021/132446
- JP-A- 2009 074 171
- JP-A- 2009 097 074
- JP-A- 2009 227 736
- JP-A- 2012 207 049
- JP-A- 2013 508 934
- JP-A- 2014 210 847
- JP-B2- 6 528 270

## Description

### Field of the Invention

The present invention relates to a metallic fine particle-containing ink, and a method of producing a printed matter using the ink.

### Background of the Invention

Metallic fine particles can form a metal film having conductivity by sintering, and therefore have been used for forming a circuit and an electrode in various electronic components, bonding components, or the like.

For example, JP 2009-74171 (PTL 1) intends to provide metallic colloid particles excellent in long-term storage stability containing metallic nanoparticles in a high concentration containing less coarse particles, and describes a dispersion liquid containing metallic colloid particles constituted by metallic nanoparticles and a protective colloid covering the metallic nanoparticles, and a solvent, in which the protective colloid is constituted by an organic compound having a carboxy group and a polymer dispersant, and the like. Additionally, JP2009074171 might be mentioned.

### Summary of the Invention

The present invention relates to a metallic fine particle-containing ink containing metallic fine particles A dispersed with a polymer B, a carboxylic acid C, and an amine D,
the polymer B having at least one kind selected from the group consisting of an organic acid group and an organic base group,
the carboxylic acid C having 1 or more and 6 or less carbon atoms,
the amine D having 1 or more and 6 or less carbon atoms, and
the metallic fine particle-containing ink having a content of the carboxylic acid C of 0.7% by mass or more and 15% by mass or less, and
a content of the amine D of 0.7% by mass or more and 20% by mass or less.

### Detailed Description of the Invention

An ink containing metallic fine particles is demanded to apply to a conductive use in printed electronics by printing on a flexible substrate, such as paper and a resin film, and to a decorative use for imparting specular gloss. In the printing using the flexible substrate, a metal film is liable to crack in flexing the flexible substrate. However, cracks in the metal film deteriorate the conductivity and the specular gloss, and therefore the resulting printed matter is demanded to have enhanced flexural resistance.

The ink containing metallic fine particles is necessarily stored under refrigeration in view of the dispersion stability of the metallic fine particles, and therefore the workability in using the ink may be deteriorated in some cases, resulting in a demand of excellent storage stability under an environment at ordinary temperature (25°C) or more.

However, it has been found that the technique of PTL 1 is insufficient in storage stability and flexural resistance.

The present invention relates to a metallic fine particle-containing ink that is excellent in storage stability and is capable of providing a printed matter excellent in flexural resistance, and a method of producing a printed matter using the ink.

The present inventors have found that: in the case where a metallic fine particle-containing ink contains metallic fine particles dispersed with a polymer, a carboxylic acid, and an amine, in which the polymer has at least one kind selected from the group consisting of an organic acid group and an organic base group, and the numbers of carbon atoms of the carboxylic acid and the amine and the contents of the carboxylic acid and the amine in the ink are respectively in the prescribed ranges, a metallic fine particle-containing ink can be provided, which ink can enhance the dispersion stability of the metallic fine particles, can form a favorable metal film, is excellent in storage stability, and can provide a printed matter excellent in flexural resistance; and a method of producing a printed matter using the ink can be provided.

Specifically, the present invention relates to the following items [1] and [2].
[1] A metallic fine particle-containing ink containing metallic fine particles A dispersed with a polymer B, a carboxylic acid C, and an amine D,
   the polymer B having at least one kind selected from the group consisting of an organic acid group and an organic base group,
   the carboxylic acid C having 1 or more and 6 or less carbon atoms,
   the amine D having 1 or more and 6 or less carbon atoms, and
   the metallic fine particle-containing ink having a content of the carboxylic acid C of 0.7% by mass or more and 15% by mass or less, and
   a content of the amine D of 0.7% by mass or more and 20% by mass or less.
[2] A method of producing a printed matter, including printing the metallic fine particle-containing ink described in the item [1] on a substrate, so as to provide a printed matter including the substrate having a conductive circuit formed thereon.

The present invention can provide a metallic fine particle-containing ink that is excellent in storage stability and is capable of providing a printed matter excellent in flexural resistance, and a method of producing a printed matter using the ink.

### [Metallic Fine Particle-containing Ink]

The metallic fine particle-containing ink of the present invention is a metallic fine particle-containing ink containing metallic fine particles A dispersed with a polymer B, a carboxylic acid C, and an amine D, in which the polymer B has at least one kind selected from the group consisting of an organic acid group and an organic base group, the carboxylic acid C has 1 or more and 6 or less carbon atoms, the amine D has 1 or more and 6 or less carbon atoms, the content of the carboxylic acid C is 0.7% by mass or more and 15% by mass or less, and the content of the amine D is 0.7% by mass or more and 20% by mass or less.

The present invention exerts an effect of achieving excellent storage stability and a printed matter excellent in flexural resistance. The mechanism therefor is not clear, but can be considered as follows.

The metallic fine particles contained in the ink of the present invention is dispersed with the polymer having at least one kind selected from the group consisting of an organic acid group and an organic base group, and it is considered that the dispersion stability of the metallic fine particles is enhanced thereby. Furthermore, the low molecular weight carboxylic acid and the low molecular weight amine having numbers of carbon atoms within the prescribed ranges are contained in the prescribed ratios, and it is considered that the dispersion stability of the metallic fine particles is enhanced through the interaction among the polymer, the low molecular weight carboxylic acid, and the low molecular weight amine. It is considered that as a result, the synergistic effect on the dispersion stability of the metallic fine particles enhances the storage stability of the ink.

After printing the metallic fine particle-containing ink, it is considered that the polymer having the metallic fine particles dispersed therein is replaced with the low molecular weight carboxylic acid and the low molecular weight amine in the drying process of the ink, and furthermore the low molecular weight carboxylic acid and the low molecular weight amine form a composite that exerts a function of a pseudo high boiling point compound to lower the volatility of the ink solvent, which gives a grace period for rearrangement of the metallic fine particles through gradual evaporation of the ink solvent from the ink film, so as to provide a printed matter having a dense metal film formed thereon, achieving the enhancement of the flexural resistance of the printed matter. In the case where the ink of the present invention is applied to the conductive use, in particular, the formation of the dense metal film can lower the volume resistivity.

In the case where ink-jet printing is used as the printing method, there is a demand of the enhancement of the open time capability as an index of printing reliability, i.e., the ink can be stably jetted even in the case where the printing is restarted after suspending the printing for a prescribed period of time. It is considered that in the ink of the present invention, as described above, the dispersion stability of the metallic fine particles is enhanced, and the composite formed of the low molecular weight carboxylic acid and the low molecular weight amine exerts a function of a pseudo high boiling point compound, so as to suppress the ink from being dried in the vicinity of the nozzle of the ink-jet head, resulting in the enhancement of the open time capability.

As described above, the present composition can achieve all the storage stability of the metallic fine particle-containing ink, the open time capability in ink-jet printing, and the flexural resistance of the printed matter, at high level.

### <Metallic Fine Particles A>

Examples of the metal (metal atom) constituting the metal fine particles A include a Group 4 transition metal, such as titanium and zirconium; a Group 5 transition metal, such as vanadium and niobium; a Group 6 transition metal, such as chromium, molybdenum, and tungsten; a Group 7 transition metal, such as manganese, technetium, and rhenium; a Group 8 transition metal, such as iron and ruthenium; a Group 9 transition metal, such as cobalt, rhodium, and iridium; a Group 10 transition metal, such as nickel, palladium, and platinum; a Group 11 transition metal, such as copper, silver, and gold; a Group 12 transition metal, such as zinc and cadmium; a Group 13 transition metal, such as aluminum, gallium, and indium; and a Group 14 transition metal, such as germanium, tin, and lead. One kind of the metal constituting the metallic fine particles A may be used as a single metal, or two or more kinds thereof may be used in combination as an alloy. Among these, the metal constituting the metallic fine particles A preferably contains a transition metal of the Groups 4 to 11 in the 4th to 6th Periods, more preferably contains copper, nickel, and a noble metal, such as gold, silver, platinum, and palladium, further preferably contains at least one kind selected from the group consisting of gold, silver, copper, nickel, and palladium, still further preferably contains at least one kind selected from the group consisting of gold, silver, copper, and nickel, still more further preferably contains at least one kind selected from the group consisting of silver, copper, and nickel, even further preferably contains silver, and even still further preferably is silver, from the standpoint of the conductivity, the standpoint of the decoration capability, the standpoint of the enhancement of the dispersion stability of the metallic fine particles, resulting in the enhancement of the storage stability and the open time capability of the ink, and the standpoint of the enhancement of the flexural resistance. The kinds of the metals can be confirmed by the high frequency induction coupled plasma emission spectroscopy.

The total content of silver, copper, and nickel in the metallic fine particles A is preferably 80% by mass or more, more preferably 90% by mass or more, further preferably 95% by mass or more, still further preferably 98% by mass or more, and still more further preferably substantially 100% by mass, from the standpoint of the conductivity, the standpoint of the decoration capability, the standpoint of the enhancement of the dispersion stability of the metallic fine particles, resulting in the enhancement of the storage stability and the open time capability of the ink, and the standpoint of the enhancement of the flexural resistance.

The content of silver in the metallic fine particles A is preferably 80% by mass or more, more preferably 90% by mass or more, further preferably 95% by mass or more, still further preferably 98% by mass or more, and still more further preferably substantially 100% by mass, from the standpoint of the conductivity, the standpoint of the decoration capability, the standpoint of the enhancement of the dispersion stability of the metallic fine particles, resulting in the enhancement of the storage stability and the open time capability of the ink, and the standpoint of the enhancement of the flexural resistance.

The expression "substantially 100% by mass" herein means that a component that is unintentionally contained may be contained. Examples of the component that is unintentionally contained include an unavoidable impurity.

### <Polymer B>

The metallic fine particles A according to the present invention are dispersed with the polymer B from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The polymer B has at least one kind selected from the group consisting of an organic acid group and an organic base group.

Examples of the organic acid group include a group exhibiting acidity by releasing a hydrogen ion through dissociation, such as a carboxy group (-COOM), a sulfonic acid group (-SO₃M), and a phosphoric acid group (-OPO₃M₂), and ionic forms thereof formed through dissociation, (such as -COO⁻, -SO₃", -OPO₃²⁻, and - OPO₃⁻M), wherein M represents a hydrogen atom, an alkali metal, ammonium, or an organic ammonium. Among these, the organic acid group is preferably a carboxy group from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

Examples of the organic base group include a primary amino group (-NH₂), a secondary amino group (-NHR¹ and =NH (imino group)), a tertiary amino group -NR¹R², and a quaternary ammonium group (-N⁺R¹R²R³). Herein, R¹ to R³ represent a methyl group, an ethyl group, a propyl group, an isopropyl group, a hydroxymethyl group, or a hydroxyethyl group. Among these, the organic base group is preferably a secondary amino group, and more preferably an imino group, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The polymer B preferably contains at least one kind selected from the group consisting of a carboxy group and an imino group, and more preferably contains a carboxy group, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The polymer B is preferably at least one kind selected from the group consisting of a polymer BI having an organic acid group and a polymer BII having an organic base group, and more preferably a polymer BI having an organic acid group, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The polymer B is preferably water soluble, more preferably at least one kind selected from the group consisting of a water soluble polymer BI having a organic acid group and a water soluble polymer BII having an organic base group, and more preferably a water soluble polymer BI having an organic acid group, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

In the present invention, the expression "water soluble" for the polymer B means that in the case where the polymer having been dried at 105°C for 2 hours to reach constant mass is dissolved in 100 g of water at 25°C, the dissolved amount thereof is 10 g or more, and preferably more than 10 g. The dissolved amount of the polymer B, for example, for the polymer BI, is the dissolved amount when the organic acid group of the polymer BI, is completely neutralized with sodium hydroxide, and for the polymer BII, is the dissolved amount when the organic base group of the polymer BII is completely neutralized with hydrochloric acid.

The polymer B preferably has a polyalkylene glycol chain from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The polyalkylene glycol chain preferably contains a unit derived from an alkylene oxide having 2 or more and 4 or less carbon atoms, such as ethylene oxide, propylene oxide, and butylene oxide, more preferably contains a unit derived from ethylene oxide or a unit derived from propylene oxide, and further preferably contains a unit derived from ethylene oxide.

### (Polymer BI)

The polymer BI has an organic acid group. Examples of the organic acid group are the same as described above. Among these, the organic acid group of the polymer BI is preferably a carboxy group.

Examples of the basic structure of the polymer BI include a vinyl-based polymer, such as an acrylic-based resin, a styrene-based resin, a styrene-acrylic-based resin, and an acrylic silicone-based resin; and a condensation -based polymer, such as a polyester and a polyurethane. Among these, the polymer BI is preferably a vinyl-based polymer containing a constitutional unit derived from a monomer (b-1) having a carboxy group from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The vinyl-based polymer is preferably a homopolymer formed of a constitutional unit derived from the monomer (b-1) or a copolymer containing a constitutional unit derived from the monomer (b-1) and a constitutional unit derived from a monomer other than the monomer (b-1). In the case where the vinyl-based polymer is a copolymer, the vinyl-based polymer may be any of a block copolymer, a random copolymer, and an alternating copolymer.

### [Monomer (b-1) having Carboxy Group]

Examples of the monomer (b-1) include an unsaturated monocarboxylic acid, such as (meth)acrylic acid, crotonic acid, and 2-methacryloyloxymethyl succinate; and an unsaturated dicarboxylic acid, such as maleic acid, itaconic acid, fumaric acid, and citraconic acid. The unsaturated dicarboxylic acid may be an anhydride.

One kind of the monomer (b-1) may be used alone, and two or more kinds thereof may be used in combination.

The monomer (b-1) is preferably at least one kind selected from the group consisting of (meth)acrylic acid and maleic acid, and more preferably (meth)acrylic acid, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

In the specification, the "(meth)acrylic acid" means at least one kind selected from the group consisting of acrylic acid and methacrylic acid. The "(meth)acrylic acid" in the following specification has the same meaning.

### [Hydrophobic Monomer (b-2)]

The polymer BI is preferably a vinyl-based polymer containing a constitutional unit derived from the monomer (b-1) having a carboxy group and a constitutional unit derived from a hydrophobic monomer (b-2) from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

In the specification, the "hydrophobic monomer" means that in the case where the monomer is dissolved in 100 g of ion exchanged water at 25°C to reach saturation, the dissolved amount thereof is less than 10 g. The dissolved amount of the monomer (b-2) is preferably 5 g or less, and more preferably 1 g or less, from the same standpoints as above.

Examples of the monomer (b-2) include a styrene-based monomer and a (meth)acrylic acid ester monomer.

The styrene-based monomer is preferably styrene and a styrene derivative, such as α-methylstyrene, 2-methylstyrene, 4-vinyltoluene (4-methylstyrene), and divinylbenzene (vinylstyrene), and more preferably styrene or α-methylstyrene, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

Examples of the (meth)acrylic acid ester include an aromatic group-containing (meth)acrylic acid ester and a (meth)acrylic acid ester having a hydrocarbon group derived from an aliphatic alcohol.

The aromatic group-containing (meth)acrylic acid ester is preferably phenyl (meth)acrylate, benzyl (meth)acrylate, phenoxyethyl (meth)acrylate, and the like, and more preferably benzyl (meth)acrylate, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The (meth)acrylic acid ester having a hydrocarbon group derived from an aliphatic alcohol is preferably a compound having a hydrocarbon group derived from an aliphatic alcohol having 1 or more and 22 or less carbon atoms from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. Examples thereof include a (meth)acrylate having a linear alkyl group, such as methyl (meth)acrylate, ethyl (meth)acrylate, propyl (meth)acrylate, butyl (meth)acrylate, pentyl (meth)acrylate, octyl (meth)acrylate, decyl (meth)acrylate, dodecyl (meth)acrylate, and stearyl (meth)acrylate; a (meth)acrylate having a branched alkyl group, such as isopropyl (meth)acrylate, isobutyl (meth)acrylate, tert-butyl (meth)acrylate, isopentyl (meth)acrylate, isooctyl (meth)acrylate, isodecyl (meth)acrylate, isododecyl (meth)acrylate, isostearyl (meth)acrylate, and 2-ethylhexyl (meth)acrylate; and a (meth)acrylate having an alicyclic alkyl group, such as cyclohexyl (meth)acrylate. Among these, the (meth)acrylate ester having a hydrocarbon group derived from an aliphatic alcohol is more preferably a compound having an alkyl group having 6 or more and 10 or less carbon atoms.

One kind of the monomer (b-2) may be used alone, or two or more kinds thereof may be used in combination.

In the specification, the "(meth)acrylate" means at least one kind selected from the group consisting of acrylate and methacrylate. The "(meth)acrylate" in the following specification has the same meaning.

The monomer (b-2) is preferably at least one kind selected from the group consisting of a styrene-based monomer and a (meth)acrylic acid ester, more preferably at least one kind selected from the group consisting of styrene, a styrene derivative, and a (meth)acrylic acid ester, further preferably at least one kind selected from the group consisting of styrene and a styrene derivative, still further preferably at least one kind selected from the group consisting of styrene, α-methylstyrene, 2-methylstyrene, and 4-vinyltoluene (4-methylstyrene), and still more further preferably at least one kind selected from the group consisting of styrene and α-methylstyrene, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

### [Monomer having Polyoxyalkylene Group (b-3)]

In the case where the polymer B has a polyalkylene glycol chain, the polymer BI is preferably a vinyl-based polymer further having a constitutional unit derived from a monomer (b-3) having a polyoxyalkylene group from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

Examples of the monomer (b-3) include a polyalkylene glycol (meth)acrylate, an alkoxypolyalkylene glycol (meth)acrylate, and a phenoxypolyalkylene glycol (meth)acrylate. One kind of the monomer (b-3) may be used alone, or two or more kinds thereof may be used in combination.

The monomer (b-3) is preferably at least one kind selected from the group consisting of a polyalkylene glycol (meth)acrylate and an alkoxypolyalkylene glycol (meth)acrylate, and more preferably an alkoxypolyalkylene glycol (meth)acrylate, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The number of carbon atoms of the alkoxy group of the alkoxypolyalkylene glycol (meth)acrylate is preferably 1 or more and 8 or less, and more preferably 1 or more and 4 or less, from the same standpoints.

Examples of the alkoxypolyalkylene glycol (meth)acrylate include methoxypolyalkylene glycol (meth)acrylate, ethoxypolyalkylene glycol (meth)acrylate, propoxypolyalkylene glycol (meth)acrylate, butoxypolyalkylene glycol (meth)acrylate, and octoxypolyalkylene glycol (meth)acrylate.

The polyoxyalkylene group of the monomer (b-3) preferably contains a unit derived from an alkylene oxide having 2 or more and 4 or less carbon atoms. Examples of the alkylene oxide include ethylene oxide, propylene oxide, and butylene oxide. Among these, the polyoxyalkylene group more preferably contains a unit derived from ethylene oxide from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The number of the unit derived from an alkylene oxide in the polyoxyalkylene group is preferably 2 or more, more preferably 5 or more, and further preferably 7 or more, and is preferably 100 or less, more preferably 70 or less, further preferably 50 or less, still further preferably 40 or less, still more further preferably 30 or less, and even further preferably 20 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The polyoxyalkylene group may be a copolymer containing a unit derived from ethylene oxide and a unit derived from propylene oxide from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The molar ratio (EO/PO) of the unit (EO) derived from ethylene oxide and the unit (PO) derived from propylene oxide is preferably 60/40 or more, more preferably 65/35 or more, and further preferably 70/30 or more, and is preferably 90/10 or less, more preferably 85/15 or less, and further preferably 80/20 or less.

The copolymer containing a unit derived from ethylene oxide and a unit derived from propylene oxide may be any of a block copolymer, a random copolymer, and an alternating copolymer.

Specific examples of the monomer (b-3) that is commercially available include NK Ester AM-90G, ditto AM-130G, ditto AMP-20GY, NK Ester M-20G, ditto 40G, ditto 90G, ditto 230G, and the like, all available from Shin-Nakamura Chemical Co., Ltd., and Blemmer PE-90, ditto 200, ditto 350, and the like, Blemmer PME-100, ditto 200, ditto 400, ditto 1000, ditto 4000, and the like, Blemmer PP-500, ditto 800, ditto 1000, and the like, Blemmer AP-150, ditto 400, ditto 550, and the like, Blemmer 50PEP-300, Blemmer 50POEP-800B, Blemmer 43PAPE-600B, and the like, all available from NOF Corporation.

### (Content of Each of Monomers in Raw Material Monomers of Polymer BI or Content of Each of Constitutional Units in Polymer BI)

In the case where the polymer BI is a vinyl-based polymer containing a constitutional unit derived from the monomer (b-1) and a constitutional unit derived from the monomer (b-2), the content of each of the monomers in the raw material monomers (which is a content in terms of the non-neutralized amount, hereinafter the same) in the production of the polymer BI or the content of the constitutional unit derived from each of the monomers in the polymer BI is as follows from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of the monomer (b-1) is preferably 0.5% by mass or more, more preferably 1% by mass or more, and further preferably 2% by mass or more, and is preferably 20% by mass or less, more preferably 10% by mass or less, and further preferably 5% by mass or less.

The content of the monomer (b-2) is preferably 30% by mass or more, more preferably 40% by mass or more, and further preferably 50% by mass or more, and is preferably 98% by mass or less, more preferably 90% by mass or less, further preferably 80% by mass or less, and still further preferably 70% by mass or less.

The mass ratio ((monomer (b-1))/(monomer (b-2)) of the monomer (b-1) and the monomer (b-2) is preferably 0.01 or more, more preferably 0.02 or more, further preferably 0.03 or more, and still further preferably 0.04 or more, and is preferably 1 or less, more preferably 0.5 or less, further preferably 0.1 or less, still further preferably 0.07 or less, and still more further preferably 0.05 or less.

In the case where the polymer BI is a vinyl-based polymer containing a constitutional unit derived from the monomer (b-3) in addition to the constitutional unit derived from the monomer (b-1) and the constitutional unit derived from the monomer (b-2), the content of the monomer (b-3) in the raw material monomers in the production of the polymer BI or the content of the constitutional unit derived from the monomer (b-3) in the polymer BI is preferably 5% by mass or more, more preferably 10% by mass or more, further preferably 15% by mass or more, still further preferably 20% by mass or more, and still more further preferably 25% by mass or more, and is preferably 50% by mass or less, more preferably 45% by mass or less, and further preferably 40% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The polymer BI used may be a polymer that is synthesized according to the known method, and may be a commercially available product. Examples of the commercially available product of the polymer BI include DISPERBYK-190 and ditto 2015, all available from BYK Chemie GmbH.

The polymer BI is preferably a vinyl-based polymer containing a constitutional unit derived from the monomer (b-1) having a carboxy group, a constitutional unit derived from the hydrophobic monomer (b-2), and a constitutional unit derived from the monomer (b-3) having a polyoxyalkylene group, and more preferably a vinyl-based polymer containing a constitutional unit derived from at least one kind selected from the group consisting of (meth)acrylic acid and maleic acid as the monomer (b-1), a constitutional unit derived from at least one kind selected from the group consisting of styrene and a styrene derivative as the monomer (b-2), and a constitutional unit derived from an alkoxypolyethylene glycol (meth)acrylate as the monomer (b-3), from the standpoint of the enhancement of the dispersion stability of the metallic fine particles, resulting in the enhancement of the storage stability and the open time capability of the ink, the standpoint of the enhancement of the flexural resistance, the standpoint of the enhancement of the low-temperature sinterability and the low-temperature bondability, and the standpoint of the reduction of the volume resistivity.

The polymer BI is preferably a vinyl-based polymer having a content of the constitutional unit derived from the monomer (b-1) of 0.5% by mass or more and 20% by mass or less, a content of the constitutional unit derived from the monomer (b-2) of 30% by mass or more and 90% by mass or less, and a content of the constitutional unit derived from the monomer (b-3) of 5% by mass or more and 50% by mass or less, and more preferably a vinyl-based polymer having a content of the constitutional unit derived from the monomer (b-1) of 0.5% by mass or more and 20% by mass or less, a content of the constitutional unit derived from the monomer (b-2) of 30% by mass or more and 70% by mass or less, and a content of the constitutional unit derived from the monomer (b-3) of 20% by mass or more and 50% by mass or less, from the standpoint of the enhancement of the dispersion stability of the metallic fine particles, resulting in the enhancement of the storage stability and the open time capability of the ink, the standpoint of the enhancement of the flexural resistance, the standpoint of the enhancement of the low-temperature sinterability and the low-temperature bondability, and the standpoint of the reduction of the volume resistivity.

The number average molecular weight Mn of the polymer BI is preferably 1,000 or more, more preferably 2,000 or more, further preferably 3,000 or more, and still further preferably 5,000 or more, and is preferably 100,000 or less, more preferably 50,000 or less, further preferably 30,000 or less, and still further preferably 10,000 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The number average molecular weight Mn can be measured according to the method described in the examples.

The acid value of the polymer BI is preferably 5 mgKOH/g or more, more preferably 10 mgKOH/g or more, and further preferably 15 mgKOH/g or more, and is preferably 800 mgKOH/g or less, more preferably 600 mgKOH/g or less, further preferably 400 mgKOH/g or less, still further preferably 200 mgKOH/g or less, still more further preferably 100 mgKOH/g or less, even further preferably 70 mgKOH/g or less, and even still further preferably 50 mgKOH/g or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The acid value of the polymer BI can be calculated from the mass ratio of the monomers constituting the polymer, and may also be obtained by titrating the polymer dissolved or swollen in a suitable solvent.

### (Polymer BII)

The polymer BII has an organic base group. Examples of the organic base group are the same as described above. Among these, the organic base group of the polymer BII is preferably a secondary amino group, and more preferably an imino group.

Examples of the polymer BII include a polyalkyleneimine, a polyallylamine, and a polyvinylamine. Among these, the polymer BII is preferably a polyalkyleneimine from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

Examples of the alkyleneimine constituting the polyalkyleneimine include an alkyleneimine having 2 or more and 8 or less carbon atoms, such as ethyleneimine, propyleneimine, 1,2-butyleneimine, 2,3-butyleneimine, and 1,1-dimethylethyleneimine, and ethyleneimine is preferred from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. One kind of the alkyleneimine may be used alone, or two or more kinds thereof may be used in combination.

The polyalkyleneimine may be linear or branched. In the case where the polyalkyleneimine is branched, a tertiary amino group and a primary amino group may be contained in the structure thereof in addition to the secondary amino group (imino group).

The weight average molecular weight Mw of the polyalkyleneimine is preferably 1,000 or more, more preferably 3,000 or more, further preferably 5,000 or more, and still further preferably 7,000 or more, and is preferably 200,000 or less, more preferably 100,000 or less, further preferably 50,000 or less, still further preferably 30,000 or less, and still more further preferably 15,000 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The weight average molecular weight Mw can be measured by gel permeation chromatography (GPC).

The polyalkyleneimine used may be a polyalkyleneimine that is synthesized according to the known method, and may be a commercially available product. Examples of the synthesis method of polyethyleneimine include a method of subjecting ethyleneimine to ring-opening polymerization with a catalyst, such as carbon dioxide, hydrochloric acid, or hydrogen bromide, a method of subjecting ethylene chloride and ethylenediamine to polycondensation, and a method of heating 2-oxazolidone.

The polyalkyleneimine may be used alone, or two or more kinds thereof may be used in combination.

In the case where the polymer B has a polyalkylene glycol chain, the polymer BII is preferably a PAI/PAO copolymer having a polyalkyleneimine (which may be hereinafter referred to as "PAI") chain and a polyalkylene glycol (polyalkylene oxide, which may be hereinafter referred to as "PAO") chain from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The PAO chain constituting the PAI/PAO copolymer preferably contains a unit derived from an alkylene oxide having 2 or more and 4 or less carbon atoms, such as ethylene oxide, propylene oxide, and butylene oxide, and is more preferably a polyethylene oxide chain containing a unit derived from ethylene oxide, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The PAI/PAO copolymer is preferably at least one kind selected from the group consisting of a PAI/PAO graft copolymer having a PAI chain as a stem and a PAO chain as a branch, a PAI/PAO copolymer having a PAO chain bonded to a network PAI chain via an amino group, and a PAI/PAO block copolymer having a PAI chain and a PAO chain.

Examples of the form of the PAI/PAO graft copolymer include a form having a linear PAI chain as a stem, and a branched PAI chain as a stem.

The bonding form of the polymer blocks of the PAI/PAO block copolymer include a diblock form and a triblock form, and specific examples of the PAI/PAO block copolymer include a PAI/PAO diblock copolymer and a PAI/PAO/PAI triblock copolymer.

The weight average molecular weight Mw of the PAI chain constituting the PAI/PAO copolymer is preferably 3,000 or more, more preferably 5,000 or more, further preferably 7,000 or more, and still further preferably 10,000 or more, and is preferably 100,000 or less, more preferably 70,000 or less, and further preferably 50,000 or less.

The weight average molecular weight Mw of the PAO chain constituting the PAI/PAO copolymer is preferably 300 or more, more preferably 500 or more, and further preferably 1,000 or more, and is preferably 50,000 or less, more preferably 30,000 or less, and further preferably 20,000 or less.

The weight average molecular weights Mw can be obtained by measuring the weight average molecular weights Mw of the PAI chain compound and the PAO chain compound as raw materials used in producing the PAI/PAO copolymer by gel permeation chromatography (GPC).

In the PAI/PAO graft copolymer, the average number of the grafted PAO chain per one PAI chain is preferably 5 or more, more preferably 10 or more, and further preferably 13 or more, and is preferably 50 or less, more preferably 40 or less, and further preferably 35 or less.

In the PAI/PAO graft copolymer, the ratio ((total number of the alkyleneimine unit having the grafted PAO chain)/(total number of alkyleneimine unit)) of the total number of the alkyleneimine unit having the grafted PAO chain with respect to the total number of alkyleneimine unit is preferably 0.01 or more, more preferably 0.015 or more, and further preferably 0.02 or more, and is preferably 0.1 or less, more preferably 0.07 or less, and further preferably 0.05 or less. The ratio ((total number of the alkyleneimine unit having the grafted PAO chain)/(total number of alkyleneimine unit)) can be measured by ¹H-NMR.

The PAI/PAO copolymer used may be a PAI/PAO copolymer that is synthesized according to the known method, and may be a commercially available product. The PAI/PAO copolymer can be obtained by a method of reacting a polyalkyleneimine and a polyoxyalkylene having a functional group capable of reacting with a nitrogen atom of the polyalkyleneimine, a method of adding an alkylene oxide to a nitrogen atom of the polyalkyleneimine, and the like. Examples of the polyoxyalkylene having a functional group capable of reacting with a nitrogen atom of the polyalkyleneimine include methoxypolyethylene glycol acetic acid.

Examples of the commercially available product of the PAI/PAO copolymer include PPE Series, available from Creative PEGWorks, Inc.

The polymer B is preferably a polymer containing at least one kind selected from the group consisting of a carboxy group and an imino group, more preferably at least one kind selected from the group consisting of a vinyl-based polymer containing a constitutional unit derived from the monomer (b-1) and a constitutional unit derived from the monomer (b-2), and a polyalkyleneimine, further preferably at least one kind selected from the group consisting of a vinyl-based polymer containing a constitutional unit derived from at least one kind selected from the group consisting of (meth)acrylic acid and maleic acid as the monomer (b-1) and a constitutional unit derived from at least one kind selected from the group consisting of styrene and a styrene derivative as the monomer (b-2), and polyethyleneimine, still further preferably a vinyl-based polymer containing a constitutional unit derived from at least one kind selected from the group consisting of (meth)acrylic acid and maleic acid as the monomer (b-1), a constitutional unit derived from at least one kind selected from the group consisting of styrene and a styrene derivative as the monomer (b-2), and a constitutional unit derived from an alkoxypolyethylene glycol (meth)acrylate as the monomer (b-3), still more further preferably a vinyl-based polymer containing a constitutional unit derived from at least one kind selected from the group consisting of (meth)acrylic acid and maleic acid as the monomer (b-1) in an amount of 0.5% by mass or more and 20% by mass or less, a constitutional unit derived from at least one kind selected from the group consisting of styrene and a styrene derivative as the monomer (b-2) in an amount of 30% by mass or more and 90% by mass or less, and a constitutional unit derived from an alkoxypolyethylene glycol (meth)acrylate as the monomer (b-3) in an amount of 5% by mass or more and 50% by mass or less, and even further preferably a vinyl-based polymer containing a constitutional unit derived from at least one kind selected from the group consisting of (meth)acrylic acid and maleic acid as the monomer (b-1) in an amount of 0.5% by mass or more and 20% by mass or less, a constitutional unit derived from at least one kind selected from the group consisting of styrene and a styrene derivative as the monomer (b-2) in an amount of 30% by mass or more and 70% by mass or less, and a constitutional unit derived from an alkoxypolyethylene glycol (meth)acrylate as the monomer (b-3) in an amount of 20% by mass or more and 50% by mass or less, from the standpoint of the enhancement of the dispersion stability of the metallic fine particles, resulting in the enhancement of the storage stability and the open time capability of the ink, the standpoint of the enhancement of the flexural resistance, the standpoint of the enhancement of the low-temperature sinterability and the low-temperature bondability, and the standpoint of the reduction of the volume resistivity.

### <Carboxylic Acid C>

The ink of the present invention contains a carboxylic acid C from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The carboxylic acid C has 1 or more and 6 or less carbon atoms, and preferably 1 or more and 3 or less carbon atoms. One kind of the carboxylic acid C may be used alone, and two or more kinds thereof may be used in combination.

Examples of the carboxylic acid C include a saturated or unsaturated linear or branched aliphatic carboxylic acid. The carboxylic acid C may have a functional group other than the carboxy group in the same molecule. Examples of the functional group include a functional group having coordinatability to the metallic fine particles, for example, a functional group having at least one kind of a hetero atom, such as an aldehyde group, a functional group containing a halogen atom, a hydroxy group, and a thiol group. Among these, the carboxylic acid C preferably has an aldehyde group in the same molecule from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

Specific examples of the carboxylic acid C include a monocarboxylic acid, such as formic acid, glyoxylic acid, acetic acid, trifluoroacetic acid, propanoic acid (propionic acid), butanoic acid (butyric acid), isobutanoic acid (isobutyric acid), pentanoic acid (valeric acid), isopentanoic acid (isovaleric acid), pivalic acid, hexanoic acid (caproic acid), and lactic acid; a dicarboxylic acid, such as oxalic acid, succinic acid, malonic acid, glutaric acid, and adipic acid; and a tricarboxylic acid, such as citric acid.

The boiling point at 1 atm of the carboxylic acid C is preferably more than 100°C, and more preferably 100.5°C or more, and is preferably 250°C or less, more preferably 210°C or less, further preferably 200°C or less, still further preferably 150°C or less, still more further preferably 135°C or less, and even further preferably 115°C or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. In the case where two or more kinds of the carboxylic acid C are used, the boiling point of the carboxylic acid C is calculated as a weighted average value.

The carboxylic acid C preferably contains a monocarboxylic acid, more preferably contains at least one kind selected from the group consisting of formic acid, acetic acid, propionic acid, butyric acid, isobutanoic acid, hexanoic acid, glyoxylic acid, and lactic acid, further preferably contains at least one kind selected from the group consisting of formic acid, acetic acid, butyric acid, hexanoic acid, and glyoxylic acid, still further preferably contains at least one kind selected from the group consisting of formic acid, hexanoic acid, and glyoxylic acid, still more further preferably contains at least one kind selected from the group consisting of formic acid and glyoxylic acid, and even further preferably contains formic acid, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of a monocarboxylic acid in the carboxylic acid C is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. Examples of the component that is unintentionally contained include the carboxylic acid C component other than the monocarboxylic acid contained in the carboxylic acid as the raw material.

The total content of formic acid, acetic acid, propionic acid, butyric acid, isobutanoic acid, hexanoic acid, glyoxylic acid, and lactic acid in the carboxylic acid C is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. For example, in the case where the total content of formic acid, acetic acid, propionic acid, butyric acid, isobutanoic acid, hexanoic acid, glyoxylic acid, and lactic acid in the carboxylic acid C is substantially 100% by mass, examples of the component that is unintentionally contained include the carboxylic acid C component other than formic acid, acetic acid, propionic acid, butyric acid, isobutanoic acid, hexanoic acid, glyoxylic acid, and lactic acid contained in the carboxylic acid as the raw material.

The total content of formic acid and glyoxylic acid in the carboxylic acid C is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. For example, in the case where the total content of formic acid and glyoxylic acid in the carboxylic acid C is substantially 100% by mass, examples of the component that is unintentionally contained include the carboxylic acid C component other than formic acid and glyoxylic acid contained in the carboxylic acid as the raw material.

### <Amine D>

The ink of the present invention contains an amine D from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The amine D has 1 or more and 6 or less carbon atoms, and the number of carbon atoms thereof is preferably 4 or less, and more preferably 3 or less, from the same standpoints, and is preferably 2 or more from the standpoint of the safety. One kind of the amine D may be used alone, or two or more kinds thereof may be used in combination.

The amine D contains at least one group of a primary amino group, a secondary amino group, or a tertiary amino group.

Specific examples of the amine D include an alkylamine, such as ethylamine, diethylamine, triethylamine, n-propylamine, di-n-propylamine, isopropylamine, diisopropylamine, n-butylamine, tert-butylamine, sec-butylamine, tert-pentylamine, n-hexylamine, N,N-dimethylethylamine, N,N-diethylmethylamine, N,N-dimethylbutylamine, and N-methylpentylamine; an alkanolamine, such as monoethanolamine, diethanolamine, triethanolamine, n-propanolamine, isopropanolamine, neopentanolamine, 4-amino-1-butanol, and 2-amino-2-methyl-1-propanol; an N-alkylmonoalkanolamine, such as N-methylethanolamine, N-ethylethanolamine, N-n-butylethanolamine, N-tert-butylethanolamine, 4-ethylamino-1-butanol, 3-(methylamino)-1-propanol, and 6-amino-1-hexanol; an N-alkyldialkanolamine, such as N-methyldiethanolamine and N-ethyldiethanolamine; an N,N-dialkylmonoalkanolamine, such as N,N-dimethylethanolamine, N,N-diethylethanolamine, N,N-dimethylpropanolamine, N,N-dimethylisopropanolamine, and 2-(dimethylamino)-2-methyl-1-propanol; an aminoalkylalkanolamine, such as N-(2-aminoethyl)ethanolamine; diethylene glycol amine; an aminoalkanediol, such as 2-amino-1,3-propanediol, 2-amino-2-ethyl-1,3-propanediol, 3-(methylamino)-1,2-propanediol, and 3-(dimethylamino)-1,2-propanediol; an N-alkylalkanediamine, such as N-methyl-1,3-propanediamine; an N,N-dialkylalkanediamine, such as N,N-dimethyl-1,3-propanediamine; allylamine; aniline; an alkylenediamine, such as ethylenediamine; and a heterocyclic amine, such as pyrrolidine, piperidine, piperazine, hydroxyethylpiperazine, and morpholine.

The boiling point at 1 atm of the amine D is preferably 30°C or more, more preferably 40°C or more, and further preferably 45°C or more, and is preferably 150°C or less, more preferably 140°C or less, further preferably 130°C or less, still further preferably 100°C or less, and still more further preferably 70°C or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. In the case where two or more kinds of the amine D are used, the boiling point of the amine D is calculated as a weighted average value.

Among these, the amine D preferably contains a primary amine, more preferably contains a monoalkylamine, further preferably at least one kind selected from the group consisting of n-propylamine, isopropylamine, n-butylamine, tert-butylamine, sec-butylamine, and n-hexylamine, still further preferably contains at least one kind selected from the group consisting of n-propylamine and n-hexylamine, and still more further preferably contains n-propylamine.

The content of a monoalkylamine in the amine D is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. Examples of the component that is unintentionally contained include the amine D component other than the monoalkylamine contained in the amine as the raw material.

The total content of n-propylamine, isopropylamine, n-butylamine, tert-butylamine, sec-butylamine, and n-hexylamine in the amine D is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. For example, in the case where the total content of n-propylamine, isopropylamine, n-butylamine, tert-butylamine, sec-butylamine, and n-hexylamine in the amine D is substantially 100% by mass, examples of the component that is unintentionally contained include the amine D component other than n-propylamine, isopropylamine, n-butylamine, tert-butylamine, sec-butylamine, and n-hexylamine contained in the amine as the raw material.

The total content of n-propylamine and n-hexylamine in the amine D is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. The expression "substantially 100% by mass" herein means that a component that is unintentionally contained may be contained. For example, in the case where the total content of n-propylamine and n-hexylamine in the amine D is substantially 100% by mass, examples of the component that is unintentionally contained include the amine D component other than n-propylamine and n-hexylamine contained in the amine as the raw material.

### <Diol E>

The ink of the present invention preferably contains a diol E from the standpoint of the enhancement of the dispersion stability of the metallic fine particles, resulting in the enhancement of the storage stability and the open time capability of the ink, the standpoint of the enhancement of the flexural resistance, the standpoint of the reduction of the volume resistivity, and the standpoint of the enhancement of the handleability of the ink. One kind of the diol E can be used alone, or two or more kinds thereof may be used in combination.

The diol E is not particularly limited, as far as the compound has two alcoholic hydroxy groups in one molecule. Examples of the diol C include a 1,2-alkanediol, such as ethylene glycol (boiling point: 197°C), propylene glycol (1,2-propanediol) (boiling point: 188°C), 1,2-butanediol (boiling point: 193°C), 1,2-pentanediol (boiling point: 206°C), and 1,2-hexanediol (boiling point: 223°C); a polyalkylene glycol, such as diethylene glycol (boiling point: 245°C), triethylene glycol (boiling point: 287°C), tetraethylene glycol (boiling point: 314°C), polyethylene glycol, dipropylene glycol (boiling point: 232°C), and tripropylene glycol (boiling point: 271°C); an α,ω-alkanediol, such as 1,3-propanediol (boiling point: 210°C), 1,4-butanediol (boiling point: 230°C), and 1,5-pentanediol (boiling point: 242°C); and 1,3-butanediol (boiling point: 208°C), 3-methyl-1,3-butanediol (boiling point: 203°C), and 2-methyl-2,4-pentanediol (boiling point: 196°C).

The boiling point at 1 atm of the diol E is preferably 70°C or more, more preferably 90°C or more, further preferably 110°C or more, still further preferably 130°C or more, and still more further preferably 150°C or more, and is preferably 300°C or less, more preferably 250°C or less, further preferably 230°C or less, and still further preferably 200°C or less, from the standpoint of the enhancement of the dispersion stability of the metallic fine particles, resulting in the enhancement of the storage stability and the open time capability of the ink, the standpoint of the enhancement of the flexural resistance, the standpoint of the reduction of the volume resistivity, and the standpoint of the enhancement of the handleability of the ink. In the case where two or more kinds of the diol E are used, the boiling point of the diol E is calculated as a weighted average value.

The diol E preferably contains at least one kind selected from the group consisting of a 1,2-alkanediol and a polyalkylene glycol, more preferably contains a 1,2-alkanediol, further preferably contains at least one kind selected from the group consisting of propylene glycol and ethylene glycol, and still further preferably contains propylene glycol, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of a 1,2-alkanediol in the diol E is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, the standpoint of the reduction of the volume resistivity, and the standpoint of the enhancement of the handleability of the ink. The expression "substantially 100% by mass" herein means that a component that is unintentionally contained may be contained. Examples of the component that is unintentionally contained include the diol E component other than the 1,2-alkanediol contained in the diol as the raw material.

The total content of propylene glycol and ethylene glycol in the diol E is preferably 80% by mass or more, more preferably 90% by mass or more, further preferably 95% by mass or more, still further preferably 98% by mass or more, and still more further preferably substantially 100% by mass, from the standpoint of the enhancement of the dispersion stability of the metallic fine particles, resulting in the enhancement of the storage stability and the open time capability of the ink, the standpoint of the enhancement of the flexural resistance, the standpoint of the reduction of the volume resistivity, and the standpoint of the enhancement of the handleability of the ink. The expression "substantially 100% by mass" herein means that a component that is unintentionally contained may be contained. Examples of the component that is unintentionally contained include the diol E component other than propylene glycol and ethylene glycol contained in the diol as the raw material.

The ink of the present invention preferably further contains water from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The ink of the present invention may further contain various additives, such as a fixing aid, e.g., a dispersion of polymer particles, a moisturizing agent, a moistening agent, a penetrating agent, a surfactant, a viscosity modifier, an antifoaming agent, an antiseptic, a fungicide, and a rust inhibitor, as an additional component other than the aforementioned components, in such a range that does not impair the effects of the present invention.

### (Production of Metallic Fine Particle-containing Ink)

The ink of the present invention can be obtained by a method in which the polymer B as a dispersant, the carboxylic acid C, the amine D, and depending on necessity the diol E, water, and the like are added and mixed with the metallic fine particles A having been prepared by the known method; a method in which a metal raw material compound, a reducing agent, and the polymer B as a dispersant are mixed to reduce the metal raw material compound, resulting in a dispersion of metallic fine particles, and then the carboxylic acid C, the amine D, and depending on necessity the diol E, water, and the like are added and mixed therewith; and the like. Among these, a method in which metallic fine particle dried powder containing the polymer B is provided in advance, and then the carboxylic acid C, the amine D, and depending on necessity the diol, water, and the like are added and mixed therewith is preferred from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The metallic fine particle dried powder can be obtained in such a manner that a metal raw material compound, a reducing agent, and the polymer B are mixed to reduce the metal raw material compound with the reducing agent, resulting in a dispersion of metallic fine particles dispersed with the polymer B, and then the dispersion of metallic fine particles is dried through freeze-drying or the like.

The metal raw material compound is not particularly limited, as far as the compound contains the metal constituting the metallic fine particles A.

Examples of the metal raw material compound include a metal salt of an inorganic acid or an organic acid, a metal oxide, a metal hydroxide, a metal sulfide, and a metal halide containing the metal exemplified for the metallic fine particles A. Examples of the metal salt include a metal salt of an inorganic acid, such as a nitrate, a nitrite, a sulfate, a carbonate, an ammonium salt, and a perchlorate; and a metal salt of an organic acid, such as an acetate. One kind of the metal raw material compound may be used alone, or two or more kinds thereof may be used as a mixture. Among these, the metal raw material compound is preferably a metal salt of an inorganic acid or an organic acid, more preferably a metal salt of an inorganic acid, further preferably a metal salt of a nitric acid, and still further preferably silver nitrate, from the standpoint of the versatility and the productivity of the metallic fine particles.

The reducing agent is not particularly limited, and any of an inorganic reducing agent and an organic reducing agent may be used, and an organic reducing agent is preferred.

Examples of the organic reducing agent include an alcohol compound, such as ethylene glycol and propylene glycol; an aldehyde compound, such as formaldehyde, acetaldehyde, and propionaldehyde; an acid compound and a salt thereof, such as ascorbic acid and citric acid; an alkanolamine, such as ethanolamine, N-methylethanolamine, N,N-dimethylethanolamine (2-(dimethylamino)ethanol), N,N-diethylethanolamine, diethanolamine, N-methyldiethanolamine, triethanolamine, propanolamine, N,N-dimethylpropanolamine, butanolamine, and hexanolamine; an alkylamine, such as n-propylamine, n-butylamine, n-hexylamine, diethylamine, dipropylamine, dimethylethylamine, diethylmethylamine, and triethylamine; an aliphatic amine, such as a (poly)alkylenepolyamine, e.g., ethylenediamine, triethylenediamine, tetramethylethylenediamine, diethylenetriamine, dipropylenetriamine, triethylenetetramine, and tetraethylenepentamine; an alicyclic amine, such as piperidine, pyrrolidine, N-methylpyrrolidine, and morpholine; an aromatic amine, such as aniline, N-methylaniline, toluidine, anisidine, and phenetidine; and an aralkylamine, such as benzylamine and N-methylbenzylamine.

Examples of the inorganic reducing agent include a hydrogenated boron salt, such as hydrogenated boron sodium and hydrogenated boron ammonium; a hydrogenated aluminum salt, such as hydrogenated aluminum lithium and hydrogenated aluminum potassium; a hydrazine compound, such as hydrazine and hydrazine carbonate; and hydrogen gas.

One kind of the reducing agent may be used alone, or two or more kinds thereof may be used in combination.

The temperature of the reduction reaction is preferably in a range of 5°C or more, more preferably 10°C or more, further preferably 20°C or more, and still further preferably 30°C or more, from the standpoint of decreasing the particle diameter of the metallic fine particles and making the particle diameter uniform, and is preferably in a range of 100°C or less, more preferably 80°C or less, and further preferably 50°C or less, from the standpoint of the stable production of the metallic fine particles. The reduction reaction may be performed in an air atmosphere, or may be performed in an inert gas atmosphere, such as nitrogen gas.

In the production of the ink of the present invention, the dispersion of metallic fine particles before freeze-drying may be purified from the standpoint of the removal of the impurities, such as the unreacted reducing agent and the excess dispersant B that does not contribute to the dispersion of the metallic fine particles A.

The method of purifying the dispersion of metallic fine particles is not particularly limited, and examples thereof include a membrane treatment, such as dialysis and ultrafiltration; and a centrifugal treatment. Among these, a membrane treatment is preferred, and dialysis is more preferred, from the standpoint of the efficient removal of the impurities. The material of the dialysis membrane used for the dialysis is preferably regenerated cellulose.

The molecular weight cut-off of the dialysis membrane is preferably 1,000 or more, more preferably 5,000 or more, and further preferably 10,000 or more, and is preferably 100,000 or less, and more preferably 70,000 or less, from the standpoint of the efficient removal of the impurities.

The ink of the present invention can be obtained by further adding the various additives described above depending on necessity, and then subjecting to a filtration treatment with a filter or the like.

### (Composition of Metallic Fine Particle-containing Ink)

The content of the metallic fine particles A in the ink of the present invention is preferably 10% by mass or more, more preferably 15% by mass or more, further preferably 20% by mass or more, and still further preferably 25% by mass or more, from the standpoint of the reduction of the volume resistivity, resulting in the enhancement of the conductivity, and the standpoint of the enhancement of the specular gloss, and is preferably 70% by mass or less, more preferably 60% by mass or less, further preferably 50% by mass or less, still further preferably 40% by mass or less, and still more further preferably 35% by mass or less, from the standpoint of the enhancement of the storage stability and the open time capability.

The content of the polymer B in the ink of the present invention is preferably 0.5% by mass or more, more preferably 1% by mass or more, further preferably 1.5% by mass or more, and still further preferably 2% by mass or more, and is preferably 10% by mass or less, more preferably 7% by mass or less, further preferably 5% by mass or less, and still further preferably 3% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of the carboxylic acid C in the ink of the present invention is 0.7% by mass or more, preferably 1% by mass or more, more preferably 1.5% by mass or more, further preferably 2% by mass or more, still further preferably 2.5% by mass or more, still further preferably 3% by mass or more, and still more further preferably 4% by mass or more, and is 15% by mass or less, preferably 10% by mass or less, and more preferably 7% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of the amine D in the ink of the present invention is 0.7% by mass or more, preferably 1% by mass or more, more preferably 1.5% by mass or more, further preferably 2% by mass or more, still further preferably 3% by mass or more, still more further preferably 4% by mass or more, even further preferably 5% by mass or more, even still further preferably 6% by mass or more, even still more further preferably 7% by mass or more, and yet further preferably 8% by mass or more, and is 20% by mass or less, preferably 17% by mass or less, more preferably 15% by mass or less, further preferably 13% by mass or less, and still further preferably 11% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The mass ratio ((amine D)/(carboxylic acid C)) of the content of the amine D with respect to the content of the carboxylic acid C in the ink of the present invention is preferably 0.5 or more, more preferably 1 or more, and further preferably 1.5 or more, and is preferably 6 or less, more preferably 5 or less, further preferably 4 or less, still further preferably 3 or less, and still more further preferably 2.5 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. In the case where the mass ratio ((amine D)/(carboxylic acid C)) is in the range, it is considered that the excess amine D that does not form the composite with the carboxylic acid C is coordinated to the surface of the metallic fine particles A, so as to enhance the dispersion stability of the metallic fine particles, resulting in the enhancement of the storage stability, the open time capability, and the flexural resistance, and the reduction of the volume resistivity. In the case where ink-jet printing is used as the printing method, the components of the ink-jet printer can be suppressed from being corroded.

In the case where the polymer B is the polymer BI having an organic acid group, the mass ratio ((amine D)/(carboxylic acid C)) of the content of the amine D with respect to the content of the carboxylic acid C in the ink of the present invention is preferably more than 1, more preferably 1.2 or more, and further preferably 1.5 or more, and is preferably 6 or less, more preferably 5 or less, further preferably 4 or less, still further preferably 3 or less, and still more further preferably 2.5 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity. In the case where the mass ratio ((amine D)/(carboxylic acid C)) is in the range, it is considered that the excess amine D that does not form the composite with the carboxylic acid C also interacts with the organic acid group of the polymer BI, and the dispersion stability of the metallic fine particles can be further enhanced thereby.

The equivalent ratio ((amine D)/(carboxylic acid C)) of the amine D with respect to the carboxylic acid C in the ink of the present invention is preferably more than 1, more preferably 1.2 or more, and further preferably 1.4 or more, and is preferably 5 or less, more preferably 4 or less, further preferably 3 or less, still further preferably 2 or less, and still more further preferably 1.8 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The total content of the carboxylic acid C and the amine D in the ink of the present invention is preferably 1.5% by mass or more, more preferably 2% by mass or more, further preferably 4% by mass or more, still further preferably 6% by mass or more, still more further preferably 8% by mass or more, even further preferably 10% by mass or more, and even still further preferably 12% by mass or more, and is preferably 35% by mass or less, more preferably 30% by mass or less, further preferably 25% by mass or less, still further preferably 20% by mass or less, and still more further preferably 18% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The mass ratio ((polymer B)/((metallic fine particles A)+(polymer B))) of the content of the polymer B with respect to the total content of the metallic fine particles A and the polymer B in the ink of the present invention is preferably 0.01 or more, more preferably 0.03 or more, and further preferably 0.05 or more, and is preferably 0.3 or less, more preferably 0.2 or less, and further preferably 0.1 or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The mass ratio ((polymer B)/((metallic fine particles A)+(polymer B))) is calculated from the masses of the metallic fine particles A and the polymer B measured according to the method described in the examples using a simultaneous thermogravimetry/differential thermal analyzer (TG/DTA).

The content of the diol E in the ink of the present invention is preferably 5% by mass or more, more preferably 10% by mass or more, and further preferably 20% by mass or more, and is preferably 60% by mass or less, more preferably 50% by mass or less, and further preferably 40% by mass or less, from the standpoint of the enhancement of the dispersion stability of the metallic fine particles, resulting in the enhancement of the storage stability and the open time capability of the ink, the standpoint of the enhancement of the flexural resistance, and the standpoint of the reduction of the volume resistivity.

The content of water in the ink of the present invention is preferably 5% by mass or more, more preferably 10% by mass or more, and further preferably 20% by mass or more, and is preferably 50% by mass or less, more preferably 40% by mass or less, and further preferably 30% by mass or less.

### (Properties of Metallic Fine Particle-containing Ink)

The average particle diameter of the metallic fine particles A contained in the ink of the present invention is preferably 3 nm or more, more preferably 10 nm or more, and further preferably 20 nm or more, and is preferably 100 nm or less, more preferably 70 nm or less, further preferably 50 nm or less, still further preferably 40 nm or less, and still more further preferably 30 nm or less, from the standpoint of the storage stability and the open time capability, the standpoint of the reduction of the volume resistivity, resulting in the enhancement of the conductivity, and the standpoint of the enhancement of the specular gloss. The average particle diameter of the metallic fine particles A can be measured according to the method described in the examples.

The viscosity at 30°C of the ink of the present invention is preferably 2 mPa ·s or more, more preferably 3 mPa ·s or more, further preferably 4 mPa ·s or more, and still further preferably 5 mPa ·s or more, and is preferably 60 mPa ·s or less, more preferably 50 mPa ·s or less, further preferably 30 mPa ·s or less, and still further preferably 10 mPa ·s or less, from the standpoint of the storage stability and the open time capability. The viscosity of the ink can be measured according to the method described in the examples with an E-type viscometer.

The pH at 20°C of the ink of the present invention is preferably 7.0 or more, more preferably 7.2 or more, and further preferably 7.5 or more, from the standpoint of the storage stability and the open time capability. The pH thereof is preferably 11 or less, more preferably 10 or less, and further preferably 9.5 or less, from the standpoint of the resistance of components and the skin irritation. The pH of the ink can be measured according to the ordinary method.

The ink of the present invention is excellent in storage stability under an environment at ordinary temperature or more, and can form a metal film excellent in flexural resistance, and therefore the ink can be favorably applied to various printing methods, such as ink-jet printing, flexographic printing, gravure printing, screen printing, offset printing, and dispenser printing. Among these, the ink of the present invention is preferably applied to ink-jet printing since the ink is excellent in open time capability as described above.

The ink of the present invention is excellent in storage stability under an environment at ordinary temperature or more, and can form a metal film excellent in flexural resistance, and therefore the ink can be applied to a wide variety of fields. Examples of the fields include a decoration material imparting specular gloss; a conductive material, such as a wiring material for forming a conductive circuit, an electrode material, and a multilayer ceramic capacitor (which may be hereinafter referred to as "MLCC"); a bonding material, such as solder; various sensors; an antenna, such as a tag for an automatic recognition system using near field communication (radio frequency identifier (which may be hereinafter referred to as "RFID")); a catalyst; an optical material; and a medical material. Among these, the ink of the present invention is preferably applied to the production of a printed matter having a conductive circuit formed thereon.

### [Method of producing Printed Matter]

The method of producing a printed matter of the present invention preferably includes printing the metallic fine particle-containing ink on a substrate, so as to provide a printed matter including the substrate having a metal film formed thereon.

The method can provide a printed matter in which a metal film excellent in conductivity, specular gloss, and the like is formed thereon. In the printing using the metallic fine particle-containing ink, the formation of a patterned printed image on a substrate can form a patterned metal film, and the patterned metal film can be used as a conductive circuit. Accordingly, the method of producing a printed matter of the present invention is preferably used as a method of producing a printed matter including a substrate having a conductive circuit formed thereon.

In the production of a printed matter in which a conductive circuit is formed, the substrate may be referred to as a "base board" in some cases.

### (Substrate)

Examples of the substrate include paper, a cloth, a resin, a metal, glass, ceramics, and a composite material thereof.

Examples of the paper substrate include coated paper (such as coated paper and art paper), uncoated paper, plain paper, craft paper, synthetic paper, processed paper, and paper board.

Examples of the cloth used as the substrate include a cloth formed of natural fibers, such as cotton, silk, and linen, or synthetic fibers, such as rayon fibers, acetate fibers, nylon fibers, and polyester fibers, and a mixed cloth formed of two or more kinds of these fibers.

Examples of the substrate formed of a resin include a synthetic resin film, such as polyethylene terephthalate (PET), polyethylene naphthalate (PEN), polybutylene terephthalate (PBT), polypropylene (PP), polyamide (PA), polyimide (PI), polyvinyl chloride (PVC), polymethyl methacrylate (PMMA), polystyrene (PS), an acrylonitrile-butadiene-styrene copolymer (ABS), an acrylonitrile-styrene copolymer (AS), and polycarbonate (PC).

Examples of the substrate formed of a metal include a base board using a metal, such as gold, silver, copper, palladium, platinum, aluminum, nickel, and tin.

Among these, at least one kind selected from the group consisting of a paper substrate and a resin substrate is preferred, and a paper substrate is more preferred, from the standpoint of the flexural resistance.

The substrate may be any of a rigid substrate and a flexible substrate, and a flexible substrate is preferred from the standpoint that the metallic fine particle-containing ink can form a metal film excellent in flexural resistance.

Preferred examples of the printing method of the metallic fine particle-containing ink on the substrate include various pattern printing methods, such as ink-jet printing, flexographic printing, gravure printing, screen printing, offset printing, and dispenser printing. The use of the pattern printing method can form a fine conductive circuit on the substrate, and can impart design excellent in specular design on the substrate.

The amount of the metallic fine particle-containing ink applied to the substrate may be appropriately regulated corresponding to the size and the kind of the circuit or the electrode to be formed, or the degree and the design of the target specular gloss.

### (Ink-jet Printing)

In the case where the metallic fine particle-containing ink of the present invention is applied to ink-jet printing, the ink may be installed in a known ink-jet printer, and jetted as ink droplets onto the substrate to form a printed image.

The ink-jet printer includes a thermal type and a piezo type, and the ink is more preferably applied to thermal type ink-jet printing.

The head temperature of the ink-jet head is preferably 15°C or more, more preferably 20°C or more, and further preferably 25°C or more, and is preferably 45°C or less, more preferably 40°C or less, and further preferably 35°C or less.

The head voltage of the ink-jet head is preferably 5 V or more, more preferably 10 V or more, and further preferably 15 V or more, and is preferably 40 V or less, more preferably 35 V or less, and further preferably 30 V or less, from the standpoint of the efficiency in printing, and the like.

The driving frequency of the head is preferably 1 kHz or more, more preferably 5 kHz or more, and further preferably 10 kHz or more, and is preferably 50 kHz or less, more preferably 40 kHz or less, and further preferably 35 kHz or less, from the standpoint of the efficiency in printing, and the like.

The jetted droplet amount of the ink according to the present invention is preferably 5 pL or more, and more preferably 10 pL or more, and is preferably 30 pL or less, and more preferably 20 pL or less, all per one droplet.

The applied amount of the ink according to the present invention in terms of solid content onto the substrate is preferably 0.5 g/m² or more, more preferably 1 g/m² or more, and further preferably 2 g/m² or more, and is preferably 20 g/m² or less, more preferably 15 g/m² or less, and further preferably 10 g/m² or less.

In the present invention, the resolution in printing is preferably 200 dpi or more, and more preferably 300 dpi or more, and is preferably 1,000 dpi or less, more preferably 800 dpi or less, and further preferably 600 dpi or less. The "resolution" in the specification herein means the number of dots per one inch (2.54 cm) formed on the substrate. For example, "resolution of 600 dpi" means that ink droplets are jetted on a substrate with a line head having nozzle holes disposed in a number of 600 dpi (dot per inch) in terms per unit length of the nozzle line, providing a line of dots of 600 dpi per one inch corresponding thereto in the direction perpendicular to the conveying direction of the substrate, and ink droplets are jetted while conveying the substrate in the conveying direction, providing a line of dots of 600 dpi per one inch also in the conveying direction of the substrate. In the specification herein, the resolution in the direction perpendicular to the conveying direction of the substrate and the resolution in the conveying direction thereof are shown as the same value.

### (Sintering Treatment)

The method of producing a printed matter of the present invention preferably includes, after printing the ink on the substrate, performing a sintering treatment of sintering the metallic fine particles Ain the ink film on the substrate, from the standpoint of the reduction of the volume resistivity, resulting in the enhancement of the conductivity, the standpoint of the enhancement of the specular gloss, and the standpoint of the enhancement of the flexural resistance.

The sintering treatment evaporates and dries the ink solvent in the ink film, and sinters the metallic fine particles A, and thereby a conductive circuit formed of a metal film having a low volume resistivity can be formed.

The temperature of the sintering treatment is preferably less than the temperature at which the substrate is deformed, and specifically, the temperature is preferably 25°C or more, more preferably 50°C or more, further preferably 100°C or more, still further preferably 120°C or more, and still more further preferably 140°C or more, and is preferably 200°C or less, more preferably 180°C or less, and further preferably 160°C or less, under ordinary pressure, from the standpoint of the reduction of the resistivity of the metal film.

The relative humidity of the surrounding environment of the sintering treatment is preferably 20% or more, more preferably 30% or more, and further preferably 40% or more, and is preferably 65% or less, and more preferably 60% or less.

In particular, the sintering treatment is preferably performed in such a manner that the metal film is treated at a high temperature of 100°C or more and then treated by storing at a low temperature. The low temperature treatment herein is preferably performed by storing at room temperature (10°C or more and 35°C or less).

The period of time of the high temperature treatment in the sintering treatment may be appropriately regulated depending on the treatment temperature, and is preferably 1 minute or more, more preferably 5 minutes or more, and further preferably 7 minutes or more, from the standpoint of the reduction of the resistivity of the metal film, and is preferably 6 hours or less, more preferably 3 hours or less, further preferably 1 hour or less, and still further preferably 30 minutes or less, from the standpoint of the productivity.

The period of time of the low temperature treatment in the sintering treatment may be appropriately regulated depending on the treatment temperature, and is preferably 1 hour or more, more preferably 3 hours or more, further preferably 6 hours or more, and still further preferably 12 hours or more, from the standpoint of the reduction of the resistivity of the metal film, and is preferably 36 hours or less, and more preferably 24 hours or less, from the standpoint of the productivity.

The sintering treatment may be performed under an air atmosphere or under an inert gas atmosphere, such as nitrogen gas, and is preferably performed under a nitrogen gas atmosphere in the case where the substrate is an easily oxidizable metal.

The method of the sintering treatment is not particularly limited, and examples thereof include a method of heating by bringing a heater into contact with the surface of the substrate opposite to the surface having the ink film formed thereon, a method of heating by applying hot air to the surface of the substrate having the ink film formed thereon, a method of heating by making a heater close to the surface of the substrate having the ink film formed thereon, a method of storing the substrate having the ink film formed thereon in a thermostat chamber capable of retaining the temperature constant, a method of heating by steam aging with high temperature steam under ordinary pressure or high pressure, and a method of heating through irradiation of light, such as near infrared light or ultraviolet light.

The volume resistivity ρv of the metal film formed by the production method of the present invention is preferably 10 µΩ ·cm or less, more preferably 7 µΩ ·cm or less, and further preferably 4 µΩ ·cm or less, and from the standpoint of the productivity of the printed matter, is preferably 2 µΩ ·cm or more, more preferably 2.5 µΩ ·cm or more, and further preferably 3 pQ ·cm or more. The volume resistivity ρv can be measured by the method described in the examples.

The printed matter obtained by the production method of the present invention has a low volume resistivity and excellent flexural resistance, and therefore can be used as a conductive composite material including a substrate and a conductive circuit in various electronic and electric equipments. The conductive composite material can be used in various devices, for example, an RFID tag, a capacitor, such as MLCC; an LTCC base board; electronic paper; an image display device, such as a liquid crystal display, an organic EL display, and a touch-sensitive panel; an organic EL device; an organic transistor; a circuit board, such as a printed circuit board and a flexible circuit board; an organic solar cell; a flexible battery; and a sensor, such as a flexible sensor.

### Examples

In Preparation Examples, Examples, and Comparative Examples below, "part" and "%" mean "part by mass" and "% by mass", respectively, unless otherwise indicated.

The properties were measured or calculated by the following methods.

### (1) Number Average Molecular Weight Mn of Polymer BI

The number average molecular weight was measured by gel permeation chromatography (GPC apparatus: HLC-8320GPC, available from Tosoh Corporation; columns: TSKgel Super AWM-H, TSKgel Super AW3000, and TSKgel guardcolumn Super AW-H, all available from Tosoh Corporation; flow rate: 0.5 mL/min) using a solution prepared by dissolving phosphoric acid and lithium bromide in N,N-dimethylformamide to make concentrations thereof of 60 mmol/L and 50 mmol/L, respectively, as an eluent, and using the monodisperse polystyrene kit having known molecular weights (PStQuick B (F-550, F-80, F-10, F-1, A-1000), PStQuick C (F-288, F-40, F-4, A-5000, A-500), all available from Tosoh Corporation, as the standard substance.

The measurement specimen used was prepared by mixing 0.1 g of the polymer BI with 10 mL of the eluent in a glass vial, stirring the resulting mixture at 25°C for 10 hours with a magnetic stirrer, and then filtering the mixture through a syringe filter (DISMIC-13HP, PTFE; 0.2 µm, available from Advantec Co., Ltd.).

### (2) Mass Ratio ((Polymer B)/((Metallic Fine Particles A)+(Polymer B)))

With a simultaneous thermogravimetry/differential thermal analyzer (TG/DTA) "STA7200RV" (available from Hitachi High-Tech Science Corporation), 10 mg of the specimen was weighed on an aluminum pan, and heated from 35°C to 550°C at a temperature rise rate of 10°C/min, and the mass decrease under a nitrogen flow of 50 mL/min was measured. The ratio ((polymer B)/((metallic fine particles A)+(polymer B))) was calculated under assumption that the mass decrease from 200°C to 550°C was the mass of the polymer B, and the remaining mass at 550°C was the mass of the metallic fine particles A.

### (3) Average Particle Diameter of Metallic Fine Particles A

The particle diameter was measured by the dynamic light scattering method with a laser particle analysis system "ELS-8000" (available from Otsuka Electronics Co., Ltd.), and the average particle diameter was calculated by the cumulant approach. The measurement condition was a temperature of 25°C, an angle between the incident light and the detector of 90°, and a cumulated number of 100, and the refractive index of the dispersion solvent was the refractive index of water (1.333). The measurement specimen was obtained in such a manner that the specimen was weighed in a screw tube (No. 5, available from Maruemu Corporation), to which water was added to make a solid concentration of 5 × 10⁻³% by mass, and the mixture was agitated with a magnetic stirrer at 25°C for 1 hour.

### (4) Measurement of Viscosity of Metallic Fine Particle-containing Ink

The viscosity at 30°C of the ink was measured with an E-type viscometer (available from Toki Sangyo Co., Ltd., Model No.: TV-25, Standard Cone Rotor 1° 34' × R24, rotation number: 100 rpm).

### Preparation Example 1 (Preparation of Polymer BI-1)

100 g of 1,4-dioxane was placed in a 1,000 mL four-neck round-bottom flask equipped with a thermometer, two dropping funnels having a 100 mL nitrogen bypass, and a reflux device, and after increasing the inner temperature of the flask to 80°C on an oil bath, nitrogen was bubbled therein for 10 minutes. Subsequently, 3 g of 98% acrylic acid (guaranteed reagent, available from Fujifilm Wako Pure Chemical Corporation), 37 g of methoxypolyethylene glycol (EO 9 mol) acrylate ("NK Ester AM-90G, available from Shin-Nakamura Chemical Co., Ltd.), and 60 g of styrene (guaranteed reagent, available from Fujifilm Wako Pure Chemical Corporation) as the raw material monomers of the polymer BI, and 1.5 g of 3-mercaptopropionic acid (guaranteed reagent, available from Fujifilm Wako Pure Chemical Corporation) were dissolved in a resin beaker, and placed in the dropping funnel (1). Separately, 20 g of 1,4-dioxane and 0.2 g of 2,2'-azobis(2,4-dimethylvaleronitrile) ("V-65", polymerization initiator, available from Fujifilm Wako Pure Chemical Corporation) were dissolved in a resin beaker, and placed in the dropping funnel (2). Subsequently, the mixtures in the dropping funnel (1) and the dropping funnel (2) were simultaneously dropped into the flask over 90 minutes. Thereafter, after increasing the temperature inside the flask to 90°C, the mixture was further agitated for 1 hour. Thereafter, the mixture was cooled to room temperature, and then distilled until the distilled matter was completed with a rotary distillation apparatus "Rotary Evaporator N-1000S" (available from Tokyo Rikakikai Co., Ltd.) at a rotation number of 50 rpm, a bath temperature of 80°C, and a pressure of 100 torr. Thereafter, the residue was dried with a vacuum dryer "VO-420" (available from Advantec Toyo Kaisha, Ltd.) at a temperature of 110°C and a pressure of 50 torr for 48 hours, so as to provide a polymer BI-1 (acrylic acid-methoxypolyethylene glycol (EO 9 mol) acrylate-styrene copolymer, acid value: 23 mgKOH/g, Mn: 8,200).

### Preparation Example 2 (Preparation of Polymer BI-2)

A polymer BI-2 (polyacrylic acid, acid value: 780 mgKOH/g, Mn: 7,700) was obtained in the same manner as in Preparation Example 1 except that the raw material monomers of the polymer BI were changed to only 100 g of 98% acrylic acid.

### Preparation Example 3 (Preparation of Polymer BI-3)

A polymer BI-3 (acrylic acid-methoxypolyethylene glycol (EO 9 mol) acrylate-styrene copolymer, acid value: 23 mgKOH/g, Mn: 7,500) was obtained in the same manner as in Preparation Example 1 except that the raw material monomers of the polymer BI were changed to 3 g of 98% acrylic acid, 17 g of methoxypolyethylene glycol (EO 9 mol) acrylate, and 80 g of styrene.

### Preparation Example 4 (Preparation of Polymer BI-4)

A polymer BI-4 (acrylic acid-styrene copolymer, acid value: 23 mgKOH/g, Mn: 5,900) was obtained in the same manner as in Preparation Example 1 except that the raw material monomers of the polymer BI were changed to 3 g of 98% acrylic acid and 97 g of styrene.

### Preparation Example 5 (Preparation of Polymer BII-1)

As the polymer BII, polyethyleneimine (reagent, weight average molecular weight: approximately 10,000, available from Fujifilm Wako Pure Chemical Corporation) was dried with a vacuum dryer "VO-420" (available from Advantec Toyo Kaisha, Ltd.) at a temperature of 110°C and a pressure of 50 torr for 48 hours, so as to provide a polymer BII-1.

### Example 1

### [Production of Metallic Fine Particle Dried Powder]

### (Step 1)

23 g of N,N-dimethylethanolamine (hereinafter referred to as "DMAE") as a reducing agent was placed in a 1,000 mL glass beaker, and heated to 40°C on an oil bath under agitation with a magnetic stirrer. Separately, 140 g of silver nitrate as a metal raw material compound, 8 g of the polymer BI-1 as a dispersant, and 70 g of ion exchanged water were placed in a 100 mL beaker, and agitated at 40°C with a magnetic stirrer until becoming visually transparent, so as to provide a mixed liquid.

Subsequently, the resulting mixed liquid was placed in a 1,000 mL dropping funnel, and the mixed liquid was dropped into DMAE retained to 40°C over 30 minutes. Thereafter, the reaction liquid was agitated for 5 hours while regulating the temperature of the reaction liquid to 40°C on an oil bath, and then air-cooled to provide a dark brown dispersion containing dispersed silver fine particles.

### (Step 2)

The entire amount of the dispersion obtained in the step 1 was placed in a dialysis tube ("Spectra Por 6", available from Repligen Corporation, dialysis membrane: regenerated cellulose, molecular weight cut-off (MWCO): 50 K), and the ends of the tube were sealed with closers. The tube was immersed in 5 L of ion exchanged water in a 5 L glass beaker, which was agitated for 1 hour while retaining the temperature of water to 20 to 25°C. Thereafter, an operation of replacing the entire amount of ion exchanged water every 1 hour was repeated three times, and then specimens were sampled every 1 hour and then the dialysis was terminated at the time when the mass ratio ((polymer B)/(metallic fine particles A)) calculated from the masses of the dispersant B and the metallic fine particles A measured by the method using a simultaneous thermogravimetry/differential thermal analyzer (TG/DTA) in the item (2) above became 2.5/30 (i.e., the mass ratio ((polymer B)/((metallic fine particles A)+(polymer B))) = 2.5/32.5), so as to provide a purified dispersion.

### (Step 3)

The purified dispersion obtained in the step 2 was freeze-dried with a freeze-dryer (Model No.: FDU-2110, available from Tokyo Rikakikai Co., Ltd.) equipped with a dry chamber (Model No.: DRC-1000, available from Tokyo Rikakikai Co., Ltd.) under drying condition (freezing at -25°C for 1 hour, decompressing at -10°C for 9 hours, and decompressing at 25°C for 5 hours, decompression degree: 5 Pa), so as to provide metallic fine particle dried powder 1.

### [Production of Metallic Fine Particle-containing Ink]

32.5 g of the metallic fine particle dried powder 1, 5 g of formic acid (guaranteed reagent, available from Fujifilm Wako Pure Chemical Corporation) as the carboxylic acid C, 10 g of n-propylamine (guaranteed reagent, available from Fujifilm Wako Pure Chemical Corporation) as the amine D, 30 g of propylene glycol as the diol E, 22.3 g of ion exchanged water, and 0.2 g of an acetylene glycol-based surfactant ("Surfynol 104PG-50, available from Nisshin Chemical Co., Ltd., a propylene glycol solution of 2,4,7,9-tetramethyl-5-decyn-4,7-diol, active ingredient: 50%) were placed in a 500 mL polyethylene beaker, and dispersed with an ultrasonic dispersion device (Model: US-3001, available from Nissei Corporation) under agitation with a magnetic stirrer for 3 hours. Thereafter, the mixture was filtered with a 5 µm disposal membrane filter (Minisart, available from Sartorius AG), so as to provide a metallic fine particle-containing ink. The resulting ink was evaluated by the following methods.

### [Ink-jet Printing]

The ink in the black cartridge of the ink-jet printer (Model No.: Deskjet 6122, available from HP, Inc., thermal type) was replaced with the metallic fine particle-containing ink in an environment of a temperature of 25±1°C and a relative humidity of 30±5%. Subsequently, the cleaning operation was performed once from the utility menu of the printer. After all the nozzles of the black head were able to jet the ink with no problem, a solid image of 204 mm in width and 275 mm in length formed with Photoshop (registered trade mark) with RGB of 0,0,0 was printed with the ink-jet printer on a commercially available paper base board ("PowerCoat XD 200", available from Arjowggings, thickness: 200 µm) as the substrate (printing condition: paper: photo gloss paper, mode: fine, gray scale).

Subsequently, the paper base board having the ink film formed thereon was heated on a hot stage at 150°C for 60 minutes, and then subjected to a sintering treatment by storing in an environment of a temperature of 25°C and a relative humidity of 55% for 24 hours, so as to provide a printed matter including the paper base board having a metal film formed thereon. The resulting printed matter was evaluated by the following methods.

### Examples 2 to 7, 12 to 18, 21, and 22 and Comparative Examples 2 to 7

Metallic fine particle-containing inks and printed matters were obtained in the same manner as in Example 1 except that in the production of the ink, the kinds of the carboxylic acid C and the amine D and the composition of the ink was changed according to Table 1.

### Examples 8 to 11 and Comparative Example 1

Metallic fine particle dried powder 2 to 5 and 51 were obtained in the same manner as in Example 1 except that in the production of metallic fine particle dried powder, the kind of the dispersant was changed as shown in Table 1. Subsequently, metallic fine particle-containing inks and printed matters were obtained in the same manner as in Example 1 except that the metallic fine particle dried powder 2 to 5 and 51, respectively were used instead of the metallic fine particle dried powder 1. In Comparative Example 1, the dispersant used was changed from the polymer BI-1 to thiomalic acid (guaranteed reagent, available from Fujifilm Wako Pure Chemical Corporation).

### Example 19

In the step 1 in the production of metallic fine particle dried powder in Example 1, 140 g of copper sulfate (guaranteed reagent, available from Fujifilm Wako Pure Chemical Corporation) as the metal raw material compound, 8 g of the polymer BI-1 as the dispersant, and 70 g of ion exchanged water were placed in a 1,000 mL glass beaker, and agitated with a magnetic stirrer at 40°C until becoming visually transparent. The mixture was heated to 40°C on an oil bath under agitation with a magnetic stirrer.

Subsequently, 25 g of hydrazine monohydrate (guaranteed reagent, available from Fujifilm Wako Pure Chemical Corporation) as the reducing agent was placed in a 100 mL dropping funnel, and dropped into the glass beaker over 3 hours. Thereafter, the reaction liquid was agitated for 5 hours while regulating the temperature of the reaction liquid to 40°C on an oil bath, and then air-cooled to provide a dispersion containing dispersed copper fine particles.

Thereafter, metallic fine particle dried powder 6 was obtained in the same manner as in the step 2 and the step 3 in Example 1. Subsequently, a metallic fine particle-containing ink and a printed matter were obtained in the same manner as in Example 1 except that metallic fine particle dried powder 6 was used instead of the metallic fine particle dried powder 1.

### Example 20

Metallic fine particle dried powder 7 was obtained in the same manner as in Example 19 except that in the step 1 of the production of the metallic fine particle dried powder, the metal raw material compound was changed from copper sulfate to anhydrous nickel chloride (reagent, available from Fujifilm Wako Pure Chemical Corporation). Subsequently, a metallic fine particle-containing ink and a printed matter were obtained in the same manner as in Example 1 except that metallic fine particle dried powder 7 was used instead of the metallic fine particle dried powder 1.

### <Evaluation>

### [Evaluation of Storage Stability]

20 g of the ink obtained in each of Examples and Comparative Examples was packed and sealed in the black cartridge of the ink-jet printer used in the ink-jet printing above, and stored in a thermostat chamber at 40°C for 14 days. Subsequently, after standing still at ordinary temperature (25°C) for 1 day, the viscosity of the ink after storing was measured in the same manner as in the measurement method above. The viscosity retention rate before and after storing was calculated according to the following expression, and designated as an index of the storage stability of the ink. The results are shown in Table 2. A viscosity retention rate closer to 100% means excellent storage stability. Viscosity retention rate (%) = ((viscosity after storing (mPa ·s))/(viscosity before storing (mPa ·s))) × 100

### [Measurement of Volume Resistivity]

The printed matter obtained in each of Examples and Comparative Examples was processed with a cross section polisher "IB-19520CCP" (available from JEOL, Ltd.), so as to provide a test piece having a flat cross sectional surface.

Subsequently, the test piece was attached to an SEM stage (Type T, available from Nisshin EM Co., Ltd.) with a double-sided adhesive tape with an aluminum substrate for SEM (catalog No. 732, available from Nisshin EM Co., Ltd.), and the cross sectional surface was observed with a field emission scanning electron microscope "FE-SEM" (available from Hitachi High-Tech Corporation, Model: S-4800) in the SEM mode under condition of an acceleration voltage of 10 kV, so as to provide a secondary electron image. The thickness of the metal film was measured at 10 points on the metal film in the secondary electron image, and the thickness t of the metal image was obtained by arithmetic average.

Subsequently, the test piece was measured with a resistivity meter (main unit: Loresta GP, four-needle probe: PSP Probe, all available from Mitsubishi Chemical Analytech Co., Ltd.), to which the thickness t of the metal film measured above was input to display the volume resistivity. The same measurement was performed on other positions of the test piece, and the volume resistivity ρv was obtained by arithmetic average of 10 points in total. The results are shown in Table 2.

### [Evaluation of Flexural Resistance]

The printed matter obtained in each of Examples and Comparative Examples was mounted on a flexing tester "Elcometer 1500 Cylindrical Mandrel on Stand" (available from Elcometer, Ltd.), and subjected to a flexural resistance test according to JIS K5600-5-1 by changing the replacement cylindrical mandrel from a diameter of 32 mm to smaller ones sequentially. The minimum diameter (mm) of the cylindrical mandrel with no crack formed was used as an index of the flexural resistance. The results are shown in Table 2. A smaller minimum diameter of the cylindrical mandrel with no crack formed means excellent flexural resistance.

### [Evaluation of Open Time Capability]

In the ink-jet printing, the cleaning operation was performed once, and then the nozzle surface was allowed to stand for 5 minutes without protecting the nozzle surface. Thereafter, the ink-jet printing was started under the same printing condition as above, and the presence of nozzle clogging was confirmed. In the case where no nozzle clogging was found, the cleaning operation was further performed once, and then the nozzle surface was allowed to stand for 10 minutes without protecting the nozzle surface and thereafter, the ink-jet printing was started under the same printing condition as above, and the presence of nozzle clogging was confirmed. The period of time of allowing to stand was similarly increased by 5 minutes to reach 180 minutes at most, and the longest period of time with no nozzle clogging was designated as the open time (minute). "Open time of 180 minutes" means that no nozzle clogging was found even after allowing to stand for 180 minutes. The results are shown in Table 2.

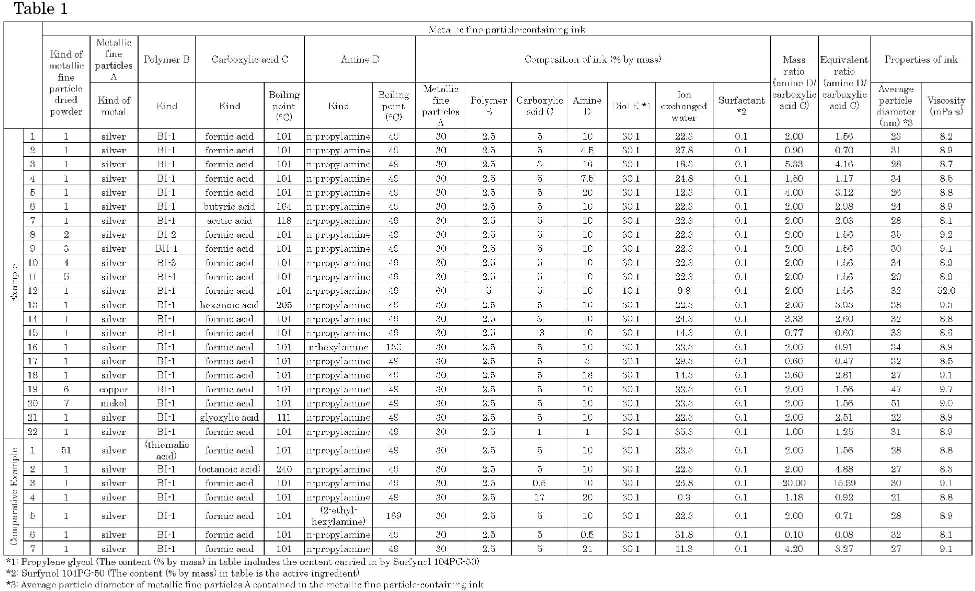

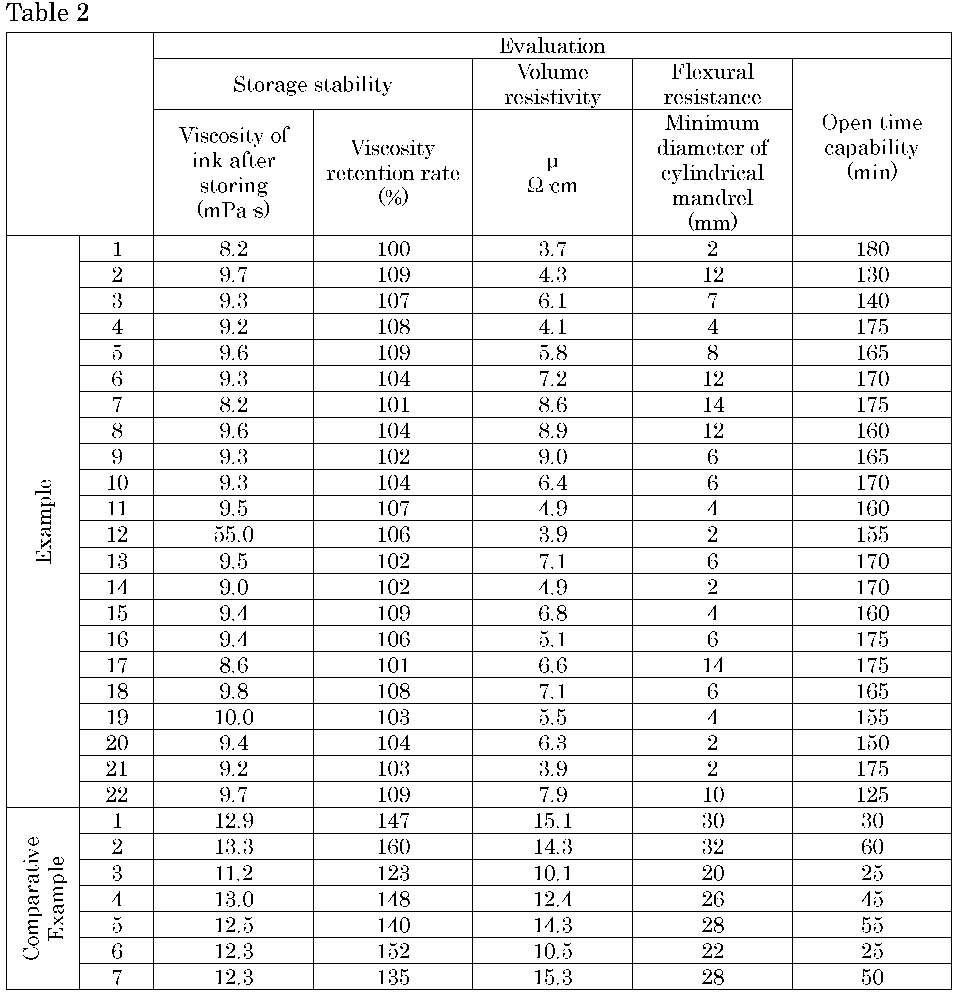

It is understood from Tables 1 and 2 that the inks of Examples 1 to 22 are excellent in storage stability and open time capability, and are capable of forming a metal film excellent in flexural resistance since the minimum diameter of the cylindrical mandrel with no crack formed is small, as compared to Comparative Examples 1 to 7. It is also understood that the inks of Examples 1 to 22 are capable of forming a metal film having a low volume resistivity, as compared to Comparative Examples 1 to 7.

### Industrial Applicability

The present invention can provide a metallic fine particle-containing ink that is excellent in storage stability under an environment at ordinary temperature or more, and is excellent in open time capability in application to inkjet printing, and can provide a printed matter having a metal film excellent in flexural resistance formed thereon. Accordingly, the metallic fine particle-containing ink of the present invention and the method of producing a printed matter using the ink can be favorably applied to a conductive use in printed electronics and a decorative use for imparting specular gloss.

## Claims

1. A metallic fine particle-containing ink comprising metallic fine particles A dispersed with a polymer B, a carboxylic acid C, and an amine D,
the polymer B having at least one kind selected from the group consisting of an organic acid group and an organic base group,
the carboxylic acid C having 1 or more and 6 or less carbon atoms,
the amine D having 1 or more and 6 or less carbon atoms, and
the metallic fine particle-containing ink having a content of the carboxylic acid C of 0.7% by mass or more and 15% by mass or less, and
a content of the amine D of 0.7% by mass or more and 20% by mass or less.

2. The metallic fine particle-containing ink according to claim 1, wherein the metallic fine particle-containing ink has a mass ratio ((amine D)/(carboxylic acid C)) of the content of the amine D with respect to the content of the carboxylic acid C of 0.5 or more and 6 or less.

3. The metallic fine particle-containing ink according to claim 1 or 2, wherein the polymer B comprises at least one kind selected from the group consisting of a carboxy group and an imino group.

4. The metallic fine particle-containing ink according to any one of claims 1 to 3, wherein the carboxylic acid C comprises a monocarboxylic acid.

5. The metallic fine particle-containing ink according to any one of claims 1 to 4, wherein the amine D comprises a monoalkylamine.

6. The metallic fine particle-containing ink according to any one of claims 1 to 5, wherein a metal constituting the metallic fine particles comprises at least one kind selected from the group consisting of silver, copper, and nickel.

7. The metallic fine particle-containing ink according to any one of claims 1 to 6, wherein the metallic fine particle-containing ink has a content of the metallic fine particles A of 10% by mass or more and 70% by mass or less.

8. The metallic fine particle-containing ink according to any one of claims 1 to 7, wherein the metallic fine particle-containing ink has a content of the polymer B of 0.5% by mass or more and 10% by mass or less.

9. The metallic fine particle-containing ink according to any one of claims 1 to 8, wherein the polymer B is a vinyl-based polymer comprising a constitutional unit derived from a monomer (b-1) having a carboxy group and a constitutional unit derived from a hydrophobic monomer (b-2).

10. The metallic fine particle-containing ink according to any one of claims 1 to 9, wherein the metallic fine particle-containing ink further comprises a diol E.

11. The metallic fine particle-containing ink according to claim 10, wherein the metallic fine particle-containing ink has a content of the diol E of 5% by mass or more and 60% by mass or less.

12. The metallic fine particle-containing ink according to any one of claims 1 to 11, wherein the metallic fine particle-containing ink has a viscosity at 30°C of 2 mPa ·s or more and 50 mPa ·s or less.

13. The metallic fine particle-containing ink according to any one of claims 1 to 12, wherein the metallic fine particle-containing ink is applied to inkjet printing.

14. A method of producing a printed matter, comprising printing the metallic fine particle-containing ink according to any one of claims 1 to 13 on a substrate, so as to provide a printed matter including the substrate having a conductive circuit formed thereon.

## Patentansprüche

1. Metallische Feinpartikel enthaltende Tinte, umfassend metallische Feinpartikel A, die mit einem Polymer B, einer Carbonsäure C und einem Amin D dispergiert sind,
wobei das Polymer B aufweist mindestens eine Art, ausgewählt aus der Gruppe, bestehend aus einer organischen Säuregruppe und einer organischen Basengruppe,
wobei die Carbonsäure C 1 oder mehr und 6 oder weniger Kohlenstoffatome aufweist,
wobei das Amin D 1 oder mehr und 6 oder weniger Kohlenstoffatome aufweist, und
wobei die metallische Feinpartikel enthaltende Tinte einen Gehalt an Carbonsäure C von 0,7 Massenprozent oder mehr und 15 Massenprozent oder weniger aufweist, und
einen Gehalt an Amin D von 0,7 Massenprozent oder mehr und 20 Massenprozent oder weniger aufweist.

2. Metallische Feinpartikel enthaltende Tinte gemäß Anspruch 1, wobei die metallische Feinpartikel enthaltende Tinte ein Massenverhältnis ((Amin D)/(Carbonsäure C)) des Gehalts an Amin D zum Gehalt an Carbonsäure C von 0,5 oder mehr und 6 oder weniger aufweist.

3. Metallische Feinpartikel enthaltende Tinte gemäß Anspruch 1 oder 2, wobei das Polymer B umfasst mindestens eine Art, ausgewählt aus der Gruppe, bestehend aus einer Carboxygruppe und einer Iminogruppe.

4. Metallische Feinpartikel enthaltende Tinte gemäß mindestens einem der Ansprüche 1 bis 3, wobei die Carbonsäure C eine Monocarbonsäure umfasst.

5. Metallische Feinpartikel enthaltende Tinte gemäß mindestens einem der Ansprüche 1 bis 4, wobei das Amin D ein Monoalkylamin umfasst.

6. Metallische Feinpartikel enthaltende Tinte gemäß mindestens einem der Ansprüche 1 bis 5, wobei ein Metall, das die metallischen Feinpartikel bildet, mindestens eine Art umfasst, ausgewählt aus der Gruppe, bestehend aus Silber, Kupfer und Nickel.

7. Metallische Feinpartikel enthaltende Tinte gemäß mindestens einem der Ansprüche 1 bis 6, wobei die metallische Feinpartikel enthaltende Tinte einen Gehalt an metallischen Feinpartikeln A von 10 Massenprozent oder mehr und 70 Massenprozent oder weniger aufweist.

8. Metallische Feinpartikel enthaltende Tinte gemäß mindestens einem der Ansprüche 1 bis 7, wobei die metallische Feinpartikel enthaltende Tinte einen Gehalt an Polymer B von 0,5 Massenprozent oder mehr und 10 Massenprozent oder weniger aufweist.

9. Metallische Feinpartikel enthaltende Tinte gemäß mindestens einem der Ansprüche 1 bis 8, wobei das Polymer B ein Polymer auf Vinylbasis ist, umfassend eine Struktureinheit, die von einem Monomer (b-1) mit einer Carboxygruppe abgeleitet ist, und eine Struktureinheit, die von einem hydrophoben Monomer (b-2) abgeleitet ist.

10. Metallische Feinpartikel enthaltende Tinte gemäß mindestens einem der Ansprüche 1 bis 9, wobei die metallische Feinpartikel enthaltende Tinte ferner ein Diol E umfasst.

11. Metallische Feinpartikel enthaltende Tinte gemäß Anspruch 10, wobei die metallische Feinpartikel enthaltende Tinte einen Gehalt an Diol E von 5 Massenprozent oder mehr und 60 Massenprozent oder weniger aufweist.

12. Metallische Feinpartikel enthaltende Tinte gemäß mindestens einem der Ansprüche 1 bis 11, wobei die metallische Feinpartikel enthaltende Tinte eine Viskosität bei 30 °C von 2 mPa·s oder mehr und 50 mPa·s oder weniger aufweist.

13. Metallische Feinpartikel enthaltende Tinte gemäß mindestens einem der Ansprüche 1 bis 12, wobei die metallische Feinpartikel enthaltende Tinte für den Tintenstrahldruck verwendet wird.

14. Verfahren zur Herstellung eines Druckerzeugnisses, umfassend das Drucken der metallischen Feinpartikel enthaltenden Tinte gemäß mindestens einem der Ansprüche 1 bis 13 auf ein Substrat, um ein Druckerzeugnis bereitzustellen, enthaltend das Substrat mit einer darauf ausgebildeten leitenden Schaltung.

## Revendications

1. Encre contenant des particules fine métalliques, comprenant des particules fines métalliques A dispersées avec un polymère B, un acide carboxylique C et une amine D,
le polymère B ayant au moins un type choisi parmi le groupe constitué d'un groupe acide organique et d'un groupe base organique,
l'acide carboxylique C ayant 1 ou plus et 6 ou moins atomes de carbone,
l'amine D ayant 1 ou plus et 6 ou moins atomes de carbone, et
l'encre contenant des particules fines métalliques ayant une teneur en acide carboxylique C de 0,7 % en masse ou plus et 15 % en masse ou moins, et
une teneur de l'amine D de 0,7 % en masse ou plus et 20 % en masse ou moins.

2. L'encre contenant des particules fines métalliques selon la revendication 1, dans laquelle l'encre contenant des particules fines métalliques a un rapport massique ((amine D)/(acide carboxylique C)) de la teneur de l'amine D par rapport à la teneur en acide carboxylique C de 0,5 ou plus et de 6 ou moins.

3. L'encre contenant des particules fines métalliques selon la revendication 1 ou 2, dans laquelle le polymère B comprend au moins un type choisi dans le groupe constitué d'un groupe carboxy et d'un groupe imino.

4. L'encre contenant des particules fines métalliques selon l'une quelconque des revendications 1 à 3, dans laquelle l'acide carboxylique C comprend un acide monocarboxylique.

5. L'encre contenant des particules fines métalliques selon l'une quelconque des revendications 1 à 4, dans laquelle l'amine D comprend une monoalkylamine.

6. L'encre contenant des particules fines métalliques selon l'une quelconque des revendications 1 à 5, dans laquelle un métal constituant les particules fines métalliques comprend au moins un type choisi dans le groupe constitué par l'argent, le cuivre et le nickel.

7. L'encre contenant des particules fines métalliques selon l'une quelconque des revendications 1 à 6, dans laquelle l'encre contenant des particules fines métalliques a une teneur en particules fines métalliques A de 10 % en masse ou plus et de 70 % en masse ou moins.

8. L'encre contenant des particules fines métalliques selon l'une quelconque des revendications 1 à 7, dans laquelle l'encre contenant des particules fines métalliques a une teneur en polymère B de 0,5 % en masse ou plus et de 10 % en masse ou moins.

9. L'encre contenant des particules fines métalliques selon l'une quelconque des revendications 1 à 8, dans laquelle le polymère B est un polymère à base de vinyle comprenant une unité constitutive dérivée d'un monomère (b-1) ayant un groupe carboxy et une unité constitutive dérivée d'un monomère hydrophobe (b-2).

10. L'encre contenant des particules fines métalliques selon l'une quelconque des revendications 1 à 9, dans laquelle l'encre contenant des particules fines métalliques comprend en outre un diol E.

11. L'encre contenant des particules fines métalliques selon la revendication 10, dans laquelle l'encre contenant des particules fines métalliques a une teneur en diol E de 5 % en masse ou plus et de 60 % en masse ou moins.

12. L'encre contenant des particules fines métalliques selon l'une quelconque des revendications 1 à 11, dans laquelle l'encre contenant des particules fines métalliques a une viscosité à 30 °C de 2 mPa·s ou plus et de 50 mPa·s ou moins.

13. L'encre contenant des particules fines métalliques selon l'une quelconque des revendications 1 à 12, dans laquelle l'encre contenant des particules fines métalliques est appliquée à l'impression à jet d'encre.

14. Procédé de production d'un imprimé, comprenant l'impression de l'encre contenant des particules fines métalliques selon l'une quelconque des revendications 1 à 13 sur un substrat, de manière à fournir un imprimé comprenant le substrat sur lequel est formé un circuit conducteur.
